# EUROPÄISCHE PATENTANMELDUNG

(11) **EP 0 727 925 A1**
(43) Veröffentlichungstag der Anmeldung: **21.08.1996**
(21) Anmeldenummer: 95101969.4
(22) Anmeldetag: 14.02.1995
(51) Int. Cl.: H05K 3/18, C23C 18/16

(54) **Verfahren zur strukturierten Metallisierung der Oberfläche von Substraten**

(71) Anmelder: LPKF CAD/CAM SYSTEME GMBH, D-30827 Garbsen (DE)
(72) Erfinder: Kickelhain, Jörg, Dipl.-Ing., D-31535 Neustadt a. Rbge. (DE)
(74) Vertreter: Braun, Dieter, Dipl.-Ing. Patentanwälte, Hagemann & Kehl

(57) **Zusammenfassung**

Beschrieben wird ein Verfahren zur strukturierten Metallisierung der Oberfläche von Substraten, insbesondere von Leiterplatten (1) auch im 3 D-Bereich unter Verwendung von elektromagnetischer UV-Strahlung (4), insbesondere eines Excimerlasers. Das Verfahren ist dadurch gekennzeichnet, daß auf die Substratoberfläche eine Primerschicht (2) im Bereich einer später aufzubringenden Metallschicht (3) vollflächig aufgetragen wird, und daß durch eine einwirkende elektromagnetische Strahlung (4) im UV-Bereich in die Primerschicht (2) Isolationskanäle (5) durch vollständigen Abtrag des Primers in bestimmten Bereichen eingearbeitet werden, und daß nachfolgend die verbliebene strukturierte Primerschicht (2) zur Bildung von Leiterbahnen (6) mit der Metallschicht (3) versehen wird. Das Verfahren ermöglicht es, Isolationskanäle (5) mit äußerster Konturenschärfe in die Primerschicht (2) auf der Oberfläche auch räumlicher, elektronischer Schaltungsträger einzubringen.

## Beschreibung

Die Erfindung betrifft ein Verfahren zur strukturierten Metallisierung der Oberfläche von Substraten, insbesondere von Leiterplatten auch im 3 D-Bereich unter Verwendung von elektromagnetischer UV-Strahlung, insbesondere eines Excimerlasers.

In der DE 39 22 478 A1 ist ein Verfahren zur Strukturierung kupferkaschierter Polymeroberflächen beschrieben, bei dem mittels Excimerlaser ein Abtrag einer Restkupferschicht und einer Kunststoffschicht erfolgt. Nachteilig wirkt sich hierbei der Abtrag einer relativ dicken Kupferschicht, vor allem hinsichtlich des hohen Zeitaufwandes aus. Ein weiterer Nachteil liegt in der für die Haftung unbedingt erforderlichen Beeinflussung der Oberfläche durch "Aufrauhung'' oder Quellung vor dem Aufbringen von beispielsweise einer PdCl₂-SnCl₂-Lösung oder anderer palladiumorganischer Verbindungen zur Aktivierung der Oberfläche. Weiterhin geht hier der Abtrag einer relativ starken Kupferschicht mit einer Wärmeentwicklung einher, die mit einer Minderung der Kantenschärfe der Struktur, insbesondere durch Ausbildung einer Sägezahnstruktur, verbunden ist und dem Trend der erforderlichen Mikrostrukturierung mit Leiterbahnbreiten von kleiner als 50 µm in der Anschluß- und Verbindungstechnik nicht gerecht wird.

In der Zeitschrift "Galvanotechnik 84" (1993), Nr. 2, Seiten 570 ff., ist andererseits in dem Artikel ''Herstellung flexibler Schaltungen mit Bayprint - eine zukunftsweisende Technologie'' ein Verfahren beschrieben, das ohne Belichtung und Ätzung arbeitet. Hier wird eine Polymeroberfläche mit einem Primer, d. h. mit einer haftvermittelnden Schicht im Siebdruckverfahren, bedruckt. Die Leiterbahnstrukturen werden hier bereits durch eine strukturierte Beschichtung mit dem Primer vorgegeben. Der Primer ist nichtleitend, haftet gut auf der Polymeroberfläche und weist nach einem Trocknungsvorgang an einer Oberseite eine poröse Struktur auf, die anschließend eine haftfeste Verankerung einer stromlos abgeschiedenen Metallschicht ermöglicht. Die Metallschicht bildet dann die Leiterbahn. Dieses Verfahren weist zwar den Vorteil auf, daß es relativ einfach zu handhaben ist, es ist jedoch bezüglich der Leiterbahnstrukturfeinheit durch Anwendung des Siebdruckes auf Leiterbahnbreiten und Isolationskanalabstände von größer als 100 µm begrenzt.

Der Erfindung liegt die Aufgabe zugrunde, die genannten Nachteile zu vermeiden und ein Verfahren zu schaffen, das eine hochauflösende strukturierte Metallisierung der Oberfläche von Substraten, insbesondere von Leiterplatten, schnell und wirtschaftlich ermöglicht.

Erfindungsgemäß wird diese Aufgabe durch die Merkmale des Anspruchs 1 gelöst. Die weitere Ausgestaltung der Erfindung ist den Unteransprüchen zu entnehmen.

Wie sich gezeigt hat, ist es dadurch, daß auf die Substratoberfläche im Bereich einer später aufzubringenden Metallschicht vollflächig eine Primerschicht aufgetragen wird, und daß durch eine einwirkende elektromagnetische Strahlung im UV-Bereich in die Primerschicht Isolationskanäle durch vollständigen Abtrag des Primers in bestimmten Bereichen eingearbeitet werden, möglich, die Isolationskanäle mit äußerster Konturenschärfe in die Primerschicht einzubringen.

Überraschenderweise ist es möglich, bei Einsatz eines Excimerlasers die Isolationskanäle durch Laserabtrag mit äußerster Konturschärfe herzustellen, obwohl bei den hier zum Einsatz kommenden Primerschichten, die sich durch einen hohen Bindemittel-Füllstoff- und Lösungsmittelanteil auszeichnen, eine hochauflösende und kantenscharfe Strukturierung im Feinstleiterbereich an sich nicht zu erwarten war.

Gleichfalls überraschend findet der Materialabtrag der Primerschicht völlig kalt statt, und es kommt zu keinerlei Aus- bzw. Aufschmelzerscheinungen an den Begrenzungen der erzeugten Isolierkanäle. Offensichtlich erfolgt der Materialabtrag der Primerbeschichtung, die frei von schwer abtragbaren Metallen in Metallbindung ist, durch die sehr hohe Photonen-Energie der verwendeten UV-Laserstrahlung.

Die hier zum Einsatz kommende Laserstrahlung im genannten Wellenlängenbereich ermöglicht es, die Polymeranteile der Primerschicht kalt aufzubrechen und somit die inhomogenen Bestandteile des Primers zu verdampfen oder aber infolge der hohen Photonen-Energie der angewandten Laserstrahlung Polymerfragmente unter Aufhebung der Bindungsenergien der Moleküle mittels des sehr hohen Plasmainnendruckes aus dem Verband herauszuschleudern.

Es sind somit extrem saubere Schnittkanten erzielbar, die mittels einer langwelligen Laserstrahlung nicht erreichbar sind.

Vorzugsweise wird die Primerschicht in den Isolationskanälen zwischen den späteren Leiterbahnen mittels eines Krypton-Fluorid-Excimerlasers mit einer Wellenlänge von 248 nm abgetragen. Wie sich gezeigt hat, ermöglicht dieser Excimerlaser einen besonders feinstrukturierten und schnellen Abtrag der Primerschicht. So ist es insbesondere bei Verwendung eines Krypton-Fluorid-Excimerlasers möglich, feinste Leiterbahnen und Isolationskanäle mit einer Breite bis zu etwa 5 µm zu strukturieren. Der Arbeitsbereich erstreckt sich von ca. 5 µm bis ca. 200 µm, insbesondere auf etwa 20 - 40 µm.

Vorteilhaft beim erfindungsgemäß vorliegenden Verfahren ist außerdem die Tatsache, daß unter Anwendung von Excimerlasern, verbunden mit dem Einsatz optischer Komponenten, sowohl die Strukturierung ebener als auch gekrümmter Substratmaterialien gelingt.

Gemäß einer bevorzugten Ausführungsform der Erfindung erfolgt der Abtrag der Primerschicht in den Isolationskanälen zwischen den späteren Leiterbahnen unter Verwendung einer im Strahlengang des Excimerlasers angeordneten Maske oder mittels eines der an sich bekannten Abbildungsverfahren. Desweiteren ist es möglich, die Primerschicht in den Isolationskanälen mittels eines fokussierten Laserstrahls abzutragen. Die genannten Verfahren ermöglichen es, den Laserstrahl fein strukturiert auf die Primerschicht einwirken zu lassen.

Es ist im übrigen von erheblichem Vorteil, daß mittels des erfindungsgemäßen Verfahrens auch räumliche elektronische Schaltungsträger, wie das Innere von Gerätegehäusen, in der beschriebenen Art und Weise mit Leiterbahnen äußerst feiner Struktur versehen werden können. Dieses rührt daher, daß alle erforderlichen Verfahrensschritte auch an gewölbten Oberflächen problemlos durchführbar sind. Auf die Oberfläche auch eines stark gewölbten Substrates kann die Primerschicht z. B. durch Aufsprühen durchaus hinreichend gleichmäßig aufgetragen werden.

Die Einwirkung der Strahlung des Excimerlasers kann beispielsweise über eine entsprechend geformte Schablone gleichfalls an beliebig gekrümmten Oberflächen von Substraten mit größter Präzision erfolgen. Nicht zuletzt bereitet der abschließende Auftrag der Metallschicht auch an gewölbten Oberflächen keine Schwierigkeiten.

Erfindungsgemäß ist es möglich, elektrische und mechanische Elemente auf nahezu beliebig geformten Leiterplatten zu integrieren. Es ergeben sich völlig neue Funktionen und neue miniaturisierte Produkte. Die sich ergebenden neuen gestalterischen und funktionalen Möglichkeiten sowie die großen Rationalisierungspotentiale sind erheblich.

Der Einsatz der Lasertechnologie im Zusammenhang mit dem hier beschriebenen Additivprozeß wird den Durchbruch der räumlichen, spritzgegossenen Schaltungsträger sehr stark beeinflussen.

Es hat sich überraschend herausgestellt, daß erfindungsgemäß, unter der Nutzung der beschriebenen Primerbeschichtung sowie einer entsprechenden Excimerlaserbestrahlung, Feinstleiterstrukturen in Additivtechnik mit einer bisher nicht gekannten Qualität zu erzeugen sind. Das Verfahren zeichnet sich vor allem aus durch:
die Möglichkeit zur Fein-, bzw. Feinstleiterstrukturierung,
eine haftfeste, additive Schaltungsherstellung,
eine Metallisierung mit unterschiedlichsten Metallen (z. B. Kupfer, Nickel, Gold, etc.),
die Nutzung von unterschiedlichsten Basismaterialarten (flex, starr-flex, starr),
den möglichen Einsatz von verschiedensten Substrattypen (PI, PE, etc.),
eine kostengünstige und schnelle Durchführung des Verfahrens,
eine flächige Strukturierung ist möglich und der Vorgang des Strukturierens der gesamten Schaltung ist in der Regel mittels weniger Laserimpulse abgeschlossen, so
daß sich eine erhebliche Zeiteinsparung ergibt,
eine Tauglichkeit der Technologie zur Massenfertigung,
einen Überraschend einfacher Verfahrensablauf und wenige Prozeßschritte, höchste Präzision.

Die Primerschicht kann direkt auf das Substrat mittels der an sich bekannten Verfahren, wie Aufstreichen, Aufsprühen, Aufdrucken, Tauchen oder Abscheiden, aufgebracht werden. Vorzugsweise wird die Primerschicht als nichtleitende Paste auf das Substrat aufgetragen.

Die Primerschicht enthält im übrigen einen Metallisierungskatalysator, der als Aktivator bezeichnet wird und der die Abscheidung der Metallschicht initiiert. Die Anwesenheit eines Aktivators ermöglicht ein späteres stromloses Aufbringen einer Metallschicht auf die nach dem Strukturieren verbliebene Primerschicht zur Bildung von Leiterbahnen. Die Metallisierung erfolgt mit Hilfe eines stromlosen Metallisierungsbades. Ein derartiges additives Aufbringen der Metallschicht unterstützt die angestrebte, sehr feine Strukturierung der Leiterbahnen. Falls eine höhere Strombelastbarkeit der Leiterzüge erforderlich ist, ist es auch möglich, eine galvanische Nachverstärkung der entsprechenden Geometrie vorzunehmen.

Ein Ausführungsbeispiel der Erfindung ist in der Zeichnung dargestellt und wird im folgenden naher beschrieben. Es zeigen:
Figur 1, einen Querschnitt durch eine Leiterplatte mit einer aufgetragenen Primerschicht,
Figur 2, einen Querschnitt durch die Leiterplatte gemäß Figur 1, mit durch die Einwirkung eines Excimerlasers abgetragenen Isolationskanälen,
Figur 3, einen Querschnitt durch die Leiterplatte gemäß Figur 1 und 2, mit einer aufgebrachten Metallschicht.

In der Zeichnung ist mit 1 eine Leiterplatte bezeichnet, die in an sich bekannter Weise aus einem nichtleitenden Polymer besteht. Auf der Oberfläche der Leiterplatte 1 ist eine Primerschicht 2 in einer Stärke von etwa 1 µm bis 15 µm, vorzugsweise 1 µm bis 10 µm aufgebracht. Das Aufbringen der Primerschicht 2 erfolgt z. B. durch Aufstreichen, Aufsprühen, Aufdrucken, Tauchen oder Abscheiden. Von Bedeutung ist es, daß die Primerschicht 2 vollflächig in den zu metallisierenden Bereichen auf die Oberfläche der Leiterplatte 1 aufgebracht ist. Die Primerschicht 2 wird bevorzugt als lösungsmittelhaltige, nichtleitende Paste aufgedruckt und ist bezüglich der Haftung auf dem Substratmaterial optimiert. Beim anschließenden Trocknen der Primerschicht 2 bildet sich an deren Oberfläche eine poröse Struktur aus. Diese poröse Struktur begünstigt die haftfeste Verankerung einer, in einem späteren Arbeitsgang auf die Primerschicht 2 aufzubringenden Metallschicht 3.

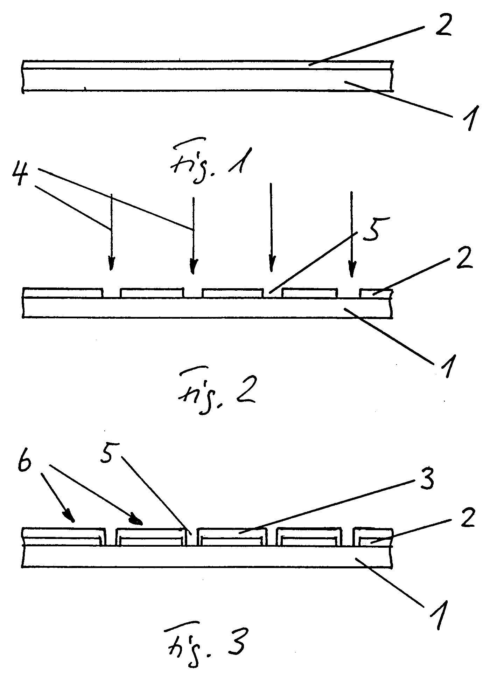

Aus der Figur 2 der Zeichnung ist ersichtlich, daß die Primerschicht 2 der Leiterplatte 1 zur Strukturierung der Strahlung 4 eines in der Zeichnung nicht dargestellten Excimerlasers ausgesetzt wird. Die Strahlung 4 bewirkt im Bereich von Isolationskanälen 5 einen Abtrag der Primerschicht 2. Wesentlich ist dabei, daß die Primerschicht 2 im Bereich der Isolationskanäle 5 vollständig abgetragen wird. Hier wirkt es sich positiv aus, daß die Intensität der Einwirkung der Strahlung 4 des Excimerlasers auf die Primerschicht 2 über die Anzahl der Pulse sehr gut einreguliert werden kann. Da das Abtragsverhalten jedes einzelnen Laserimpulses bekannt ist, läßt sich die Primerschicht 2 sauber und sehr kantenscharf vollständig entfernen. Es ist somit auch möglich, den Abtrag an der Polymeroberfläche der Leiterplatte 1 auf ein Minimum zu reduzieren.

Dies ist unter anderem sehr bedeutsam wegen der Beibehaltung von elektrischen, mechanischen Eigenschaften des Trägersubstrates, aber auch im Hinblick auf den bekannten Effekt einer möglichen Fremdabscheidung an vorher exponierten laserbestrahlten Flächen. Die Einwirkzeit und Intensität der eingestrahlten Laserenergie bestimmt hier maßgeblich die Schaffung von Aktivierungszentren und somit die Stärke einer späteren ungewollten Fremdabscheidung und Metallisierung durch das stromlose Metallisierungsbad.

Bedingt durch den Umstand des zeitlich äußerst kurzen und hervorragend zu kontrollierenden Tiefenabtrages der Laserstrahlung sinkt innerhalb dieses angestrebten Verfahrens die Wahrscheinlichkeit, am Boden der Isolationskanäle eine unerwünschte Fremdabscheidung im Rahmen der späteren stromlosen Metallisierung zu produzieren.

Die Begrenzung der Strahlung 4 auf den Bereich der Isolationskanäle 5 der Primerschicht 2 erfolgt beispielsweise durch die Anordnung einer Maske im Strahlengang des Excimerlasers. Selbstverständlich ist es auch möglich, mittels eines Abbildungsverfahrens bzw. mittels eines fokussierten Laserstrahls, die Primerschicht 2 sehr fein strukturiert abzutragen. Grundsätzlich hat es sich gezeigt, daß die Primerschicht 2 überraschend gut zum Abtrag mittels z. B. der Strahlung eines Excimerlasers mit einer Wellenlänge von 248 nm geeignet ist, da die Primerschicht 2 keine in Metallbindung vorliegenden Metalle enthält, deren Abtrag sich bekanntlich mittels eines Excimerlasers äußerst schwierig gestaltet. Die Bindungsenergie der Moleküle der Primerschicht 2 wird hier durch die hohe Photonen-Energie der genannten Excimerlaser-Strahlung leicht aufgehoben, so daß ein äußerst schneller Materialabtrag ohne jede Erwärmung erfolgt. Dieses hat zur Folge, daß die Wandungen im Bereich des Materialabtrags außergewöhnlich scharf geschnitten werden. Es ist somit möglich, in der Primerschicht 2 feinste Strukturen mit einer Breite von bis zu etwa 5 µm zu erzeugen. Der bevorzugte Bereich liegt bei 40 µm bis 20 µm. Beim Abtrag der Primerschicht 2 ist jedoch zu beachten, daß die später aufgebrachte Metallschicht 3 möglicherweise auch an den Rändern der Isolationskanäle 5 aufgebaut wird. Die Isolationskanäle 5 müssen aus diesem Grunde an jedem dieser Ränder um die Stärke der aufgebrachten Metallschichten 3 breiter abgetragen werden, als es an sich für die Isolierung erforderlich ist.

Nach dem Abtragen der Primerschicht 2 im Bereich der Isolierkanäle 5 wird auf die verbliebene strukturierte Primerschicht 2, wie in Figur 3 dargestellt, die Metallschicht 3 aufgebracht. Es handelt sich um eine elektrisch nichtleitende Primerschicht 2, die Metallisierungsaktivatoren in Form von Schwermetallverbindungen, vorzugsweise Palladium/Silber-Verbindungen, enthält, die ein späteres Aufbringen der Metallschicht 3 aus einem stromlosen Metallisierungsbad ermöglichen.

Die stromlose Metallisierung gewährleistet eine außerordentlich gleichmäßige Schichtstärke. Die aufgebrachten Metallschichten 3 können zudem extrem dünn gehalten werden, wobei Schichtdicken mit einer Stärke von 0,5 - 30 µm, bevorzugt 1 - 10 µm, eingestellt werden.

Der zu strukturierende Primer besteht beispielsweise nach der DE 37 43 780 A1 der Firma BAYER AG aus folgenden Komponenten:
0,03 - 4,00 Gew.-% einer katalytisch wirkenden Substanz als Aktivator,
3 - 40 Gew.-% eines Polyimides als Bindemittel,
1 - 30 Gew.-% eines Füllstoffes und
45 - 90 Gew.-% eines Lösungsmittels
und wird beispielsweise zur haftfesten Metallisierung von Polyimidmaterialien in folgender Weise hergestellt:
Aus 4,4-Diphenylmethan-diisocyanat und Trimellitsäureanhydrid wird in N-Methylpyrrolidon eine 40-%ige Lösung eines aromatischen Polyamidimids hergestellt. Dann werden 250 Gew.-Teile dieser Lösung des aromatischen Polyamidimids, 90 Gew.-Teile Propylenglykolmethyletheracetat, 2 Gew.-Teile 3-Hepten-2-on-palladiumchlorid und 15 Gew.-Teile Aerosil (200 m²/g nach BET) in einer Perlmühle sorgfältig miteinander vermischt bzw. dispergiert.

Der Primer wird vorzugsweise durch Aufdrucken oder Aufsprühen auf das Substrat, d. h. auf die Leiterplatte 1, aufgetragen. Das Substrat wird dann zusammen mit dem aufgebrachten Primer bei einer Temperatur von ca. 250 °C eine Stunde lang getrocknet.

Danach wird der Schichtverbund einer flächig wirkenden Excimerlaserstrahlung ausgesetzt. Die partiell unterschiedliche Energiedichteverteilung des sekundären Laserstrahles bewirkt die Einarbeitung von Isolationskanälen in die Primerschicht. Diese Strukturierung, d. h. der partielle Abtrag, erfolgt durch die Übertragung der Layoutinformation auf die Substratoberfläche mittels verschiedenartiger Verfahren:
a) Kontaktmaske (1:1 Abbildung)
b) Masken- oder Waferprojektion (verkleinerte Abbildung)
c) Diffraktive Optiken (spezielle optische Komponenten)
d) Fokussierte Bearbeitung.

Nach Fertigstellung dieser Leiterbilder, d. h. der Leiterbahnen 6 und Isolationskanäle 5, erfolgt die Metallisierung der verbliebenen Primergeometrien mittels eines handelsüblichen stromlosen Metallisierungsbades (ca. 2 µm Metallstärke in 1 Sekunde). Die hervorragende Haftung der abgeschiedenen Metallschichten liegt im Bereich von ca. 60 N/inch.

## Patentansprüche

1. Verfahren zur strukturierten Metallisierung der Oberfläche von Substraten, insbesondere von Leiterplatten (1) auch im 3 D-Bereich unter Verwendung von elektromagnetischer UV-Strahlung (4), insbesondere eines Excimerlasers, dadurch gekennzeichnet, daß auf die Substratoberfläche eine Primerschicht (2) im Bereich einer später aufzubringenden Metallschicht (3) vollflächig aufgetragen wird, und daß durch eine einwirkende elektromagnetische Strahlung (4) im UV-Bereich in die Primerschicht (2) Isolationskanäle (5) durch vollständigen Abtrag des Primers in bestimmten Bereichen eingearbeitet werden, und daß nachfolgend die verbliebene strukturierte Primerschicht (2) zur Bildung von Leiterbahnen (6) mit der Metallschicht (3) versehen wird.

2. Verfahren nach Anspruch 1, dadurch gekennzeichnet, daß die Isolationskanäle (5) um die Stärke der auch an Rändern der Primerschicht (2) aufgebrachten Metallschicht (3) breiter, als es an sich für die Isolierung der Leiterbahnen (6) erforderlich ist, in die Primerschicht (2) eingearbeitet werden, derart, daß die aufgebrachte Metallschicht (3) ausreichend breite Isolationskanäle (5) offen läßt.

3. Verfahren nach den Ansprüchen 1 und 2, dadurch gekennzeichnet, daß die Primerschicht (2) in den Isolationskanälen (5) zwischen den späteren Leiterbahnen (6) mittels eines Krypton-Fluorid-Excimerlasers mit einer Wellenlänge von 248 nm abgetragen wird.

4. Verfahren nach den Ansprüchen 1 bis 3, dadurch gekennzeichnet, daß feinste Leiterbahnen (6) und Isolationskanäle (5) mit einer Breite von 5 µm bis 200 µm, vorzugsweise 10 µm bis 100 µm, erzeugt werden.

5. Verfahren nach wenigstens einem der vorhergehenden Ansprüche, dadurch gekennzeichnet, daß der Abtrag der Primerschicht (2) in den Isolationskanälen (5) zwischen den späteren Leiterbahnen (6) unter Verwendung einer im Strahlengang des Excimerlasers angeordneten Maske oder mittels eines Abbildungsverfahrens erfolgt.

6. Verfahren nach wenigstens einem der vorhergehenden Ansprüche, dadurch gekennzeichnet, daß der Abtrag der Primerschicht (2) in den Isolationskanälen (5) mittels eines fokussierten Laserstrahls erfolgt.

7. Verfahren nach wenigstens einem der vorhergehenden Ansprüche, dadurch gekennzeichnet, daß die Primerschicht (2) auf das Substrat durch Aufstreichen, Aufsprühen, Aufdrucken, Tauchen oder Abscheiden aufgebracht wird.

8. Verfahren nach wenigstens einem der vorhergehenden Ansprüche, dadurch gekennzeichnet, daß die Primerschicht (2) als nichtleitende Paste auf das Substrat aufgetragen wird und Komponenten mit Aktivatoren für die stromlose Metallisierung enthält.

9. Verfahren nach wenigstens einem der vorhergehenden Ansprüche, dadurch gekennzeichnet, daß ein stromloses Aufbringen der Metallschicht (3) auf die verbliebene Primerschicht (2) zur Bildung der Leiterbahnen (6) mit Hilfe stromloser Metallisierungsbäder erfolgt.

10. Verfahren nach wenigstens einem der vorhergehenden Ansprüche, dadurch gekennzeichnet, daß die metallisierten Leiterbahnen (6) galvanisch verstärkt werden.
